# EUROPÄISCHE PATENTSCHRIFT

(11) **EP 3 285 556 B1**
(45) Veröffentlichungstag und Bekanntmachung des Hinweises auf die Patenterteilung: **17.02.2021**
(21) Anmeldenummer: 17175505.1
(22) Anmeldetag: 12.06.2017
(51) Int. Cl.: H05K 7/20

(54) **KÜHLANORDNUNG FÜR DIE KLIMATISIERUNG EINER IT-UMGEBUNG UND INSBESONDERE FÜR DIE RECHENZENTRUMSKLIMATISIERUNG**
COOLING ASSEMBLY FOR AIR CONDITIONING AN IT ENVIRONMENT AND IN PARTICULAR FOR DATA CENTRE AIR CONDITIONING
SYSTÈME DE REFROIDISSEMENT POUR LA CLIMATISATION D'UN ENVIRONNEMENT INFORMATIQUE ET EN PARTICULIER POUR LA CLIMATISATION D'UN CENTRE DE CALCUL

(30) Priorität: 16.08.2016 DE 102016115175
(43) Veröffentlichungstag der Anmeldung: 21.02.2018
(73) Patentinhaber: Rittal GmbH & Co. KG, 35745 Herborn (DE)
(72) Erfinder: Lazarro, Andrea, 35020 Saonara (IT)
(74) Vertreter: Angerhausen, Christoph

(56) Entgegenhaltungen:
- US-A1- 2008 250 807

## Beschreibung

Die Erfindung geht aus von einer Kühlanordnung für die Klimatisierung einer IT-Umgebung und insbesondere für die Rechenzentrumsklimatisierung, wobei die Kühlanordnung ein Kühlgerätegehäuse aufweist, das in einer IT-Umgebung und insbesondere in einem Rechenzentrum aufgestellt ist, und in dem ein erstes Wärmetauscherpaket sowie mindestens ein erster Lüfter aufgenommen sind. Der erste Lüfter ist dazu eingerichtet, Luft aus dem Gebäude- oder dem Rechenzentrumsinnern über eine erste von zwei gegenüber liegenden Gehäuseseiten des Kühlgerätegehäuses anzusaugen, durch das Kühlgerätegehäuse und das erste Wärmetauscherpaket hindurch zu befördern und über eine der ersten Gehäuseseite gegenüber liegende zweite Gehäuseseite aus dem Gehäuse auszublasen. Außerhalb des Gebäudes oder Rechenzentrums ist ein zweites Wärmetauscherpaket angeordnet und von einem zweiten Lüfter mit Luft durchströmt. Ein erster und ein zweiter Kältemittelkreislauf sind fluidisch voneinander getrennt zwischen dem ersten Wärmetauscherpaket und dem zweiten Wärmetauscherpaket geführt, wobei der erste Kältemittelkreislauf ein Freikühlungskreislauf und der zweite Kältemittelkreislauf ein Verdichterkreislauf ist, wobei das zweite Wärmetauscherpaket einen dritten Luft-Kältemittel-Wärmetauscher, der ein Verflüssiger des Verdichterkreislaufs ist, und einen vierten Luft-Kältemittel-Wärmetauscher aufweist, durch den das flüssige Kältemittel des Freikühlungskreislaufs durchgeleitet ist. Eine derartige Kühlanordnung ist in der US 2008/0250807A1 beschrieben.

Eine weitere Kühlanordnung ist in der DE 10 2013 111 053 A1 beschrieben.

Insbesondere bei Klimatisierungsanwendungen im Rechenzentrumsbereich, bei denen die Kühlgerätegehäuse beispielsweise als Inline-Geräte in eine Schaltschrankreihe integriert sein können, können die je Kühlanordnung aufzubringenden Kühlleistungen im Bereich von beispielsweise 35 kW oder darüber liegen, was es wiederum erforderlich macht, dass die im Außenbereich das zweite Wärmetauscherpaket aufweisenden Rückkühleinheiten als aktive Rückkühler, beispielsweise als Chiller, ausgebildet sind, um die für die aufzubringende Kühlleistung im Gebäude bzw. Rechenzentrum erforderliche Rückkühlung bereitstellen zu können.

Die Kühleffizienz von Kältemaschinen ist jedoch stark von den Temperaturverhältnissen zwischen dem Gebäude bzw. Rechenzentrum und der Umgebung des Rechenzentrums abhängig, insbesondere von der Temperaturdifferenz zwischen einer Soll- oder Ist-Temperatur im Gebäude bzw. Rechenzentrum und der Außenumgebung des Rechenzentrums, wobei die Temperatur der Außenumgebung des Rechenzentrums stark jahreszeitenabhängig ist. Insbesondere ist daher die Rückkühlleistung des Chillers daher darauf ausgelegt, auch bei maximalen Außentemperaturen, beispielsweise bei Temperaturen von mehr als 35 °C, immer noch eine ausreichende Rückkühlung bereitstellen zu können. Da diese extremen Temperaturen in vielen Regionen der Erde jedoch an nur vergleichsweise wenigen Tagen im Jahr erreicht werden, arbeitet der Chiller die allermeiste Zeit in einem, gemessen an seiner Auslegung, ineffizienten Kühlleistungsbereich.

Es ist daher die Aufgabe der Erfindung, eine Kühlanordnung der eingangs beschriebenen Art derart weiter zu entwickeln, dass sie auch bei variierenden Umgebungstemperaturen energieeffizient betrieben werden kann. Diese Aufgabe wird durch eine Kühlanordnung mit den Merkmalen des Anspruchs 1 gelöst. Vorteilhafte Ausführungsformen der Erfindung sind Gegenstand der abhängigen Ansprüche.

Demgemäß ist vorgesehen, dass der dritte und der vierte Wärmetauscher des zweiten Wärmetauscherpakets vertikal übereinander gestapelt in einem Rückkühlgehäuse aufgenommen sind, wobei der Verflüssiger des Verdichterkreislaufs oberhalb des vierten Luft-Kältemittel-Wärmetauscher des Freikühlungskreislaufs angeordnet ist und der Verflüssiger und der vierte Luft-Kältemittel-Wärmetauscher des Freikühlungskreislaufs in Vertikalrichtung nacheinander von der Luft durchströmt sind.

Durch die Kombination eines Freikühlungskreislaufes und eines Verdichterkreislaufes wird erreicht, dass die aufzubringende Kühlleistung zumindest anteilig über den Freikühlungskreislauf bereitgestellt werden kann, so dass der Verdichterkreislauf durch den Freikühlungskreislauf entlastet wird. Dies wiederum bedingt, dass die von dem Verdichterkreislauf eventuell noch zusätzlich zu der Kühlleistung des Freikühlungskreislaufes aufzubringende Kühlleistung so gering ist, dass die über das zweite Wärmetauscherpaket im Außenbereich bereitzustellende Rückkühlleistung entsprechend niedrig ist und es insbesondere erlaubt, dass die Rückkühlung des Verdichterkreislaufes über das zweite Wärmetauscherpaket allein über einen als Luft-Kältemittel-Wärmetauscher ausgebildeten Verflüssiger des Verdichterkreislaufes bereitgestellt werden kann und somit die Anwendung Energie verbrauchender Rückkühlgeräte, insbesondere die Anwendung von Chillern, nicht mehr erforderlich ist.

Das erste Wärmetauscherpaket kann daher einen ersten Luft-Kältemittel-Wärmetauscher, der ein Verdampfer des Verdichterkreislaufs ist, und einen zweiten Luft-Kältemittel-Wärmetauscher aufweisen, durch den das flüssige Kältemittel des Freikühlungskreislaufs durchgeleitet ist. Dementsprechend weist das zweite Wärmetauscherpaket einen dritten Luft-Kältemittel-Wärmetauscher, der ein Verflüssiger des Verdichterkreislaufs ist, und einen vierten Luft-Kältemittel-Wärmetauscher auf, durch den das flüssige Kältemittel des Freikühlungskreislaufs durchgeleitet ist.

Die das zweite Wärmetauscherpaket durchströmende Luft kann in Luftströmungsrichtung durch das zweite Wärmetauscherpaket den vierten Luft-Kältemittel-Wärmetauscher des Freikühlungskreislaufs vor dem Verflüssiger des Verdichterkreislaufs durchströmen.

Die beschriebene Kühlanordnung ermöglicht es insbesondere auch, dass eine Rückkühleinheit, die im Außenbereich angeordnet ist und das zweite Wärmetauscherpaket aufweist, als ein kompaktes Bauteil ausgebildet sein kann. Insbesondere ist es möglich, dass durch die Ausbildung des dritten und des vierten Wärmetauschers als Luft-Kältemittel-Wärmetauscher die beiden Wärmetauscher in Luftströmungsrichtung durch die beiden Wärmetauscher hintereinander geschaltet werden können und dementsprechend derselbe Lüfter oder dieselben Lüfter für die Durchströmung beider Wärmetauscher verwendet werden können. Insbesondere werden auch zusätzliche Pumpen, Verdichter, Expansionsmittel und dergleichen überflüssig.

Eine Lufteinlassseite des vierten Luft-Kältemittel-Wärmetauschers des Freikühlungskreislaufs kann einen Lufteinlass des zweiten Wärmetauscherpakets und eine Luftauslassseite des Verflüssigers einen Luftauslass des zweiten Wärmetauscherpakets bilden.

Die Seitenwände des Rückkühlgehäuses können von einer umlaufend geschlossenen vertikalen Seitenwandeinfassung des zweiten Wärmetauscherpakets gebildet sein, die den dritten und den vierten Wärmetauscher zueinander ausrichtet und seitlich einfasst, so dass eine Luftströmungsrichtung durch das zweite Wärmetauscherpaket parallel zu der Seitenwandeinfassung und damit in Vertikalrichtung gebildet ist.

Die Luft-Kältemittel-Wärmetauscher des zweiten Wärmetauscherpakets können parallele Wärmetauscherlamellen aufweisen, von denen benachbarte Wärmetauscherlamellen jeweils einen in Vertikalrichtung durchlässigen Luftleitkanal durch den dritten und den vierten Luft-Kältemittel-Wärmetauscher hindurch bilden.

Die Luftleitkanäle des dritten und des vierten Luft-Kältemittel-Wärmetauschers des zweiten Wärmetaucherpakets können paarweise fluchtend zueinander ausgerichtet sein, wobei die fluchtenden Luftleitkanäle jeweils zwischen der Lufteinlassseite des vierten Luft-Kältemittel-Wärmetauschers des Freikühlungskreislaufs und der Luftauslassseite des Verflüssigers geführt sind.

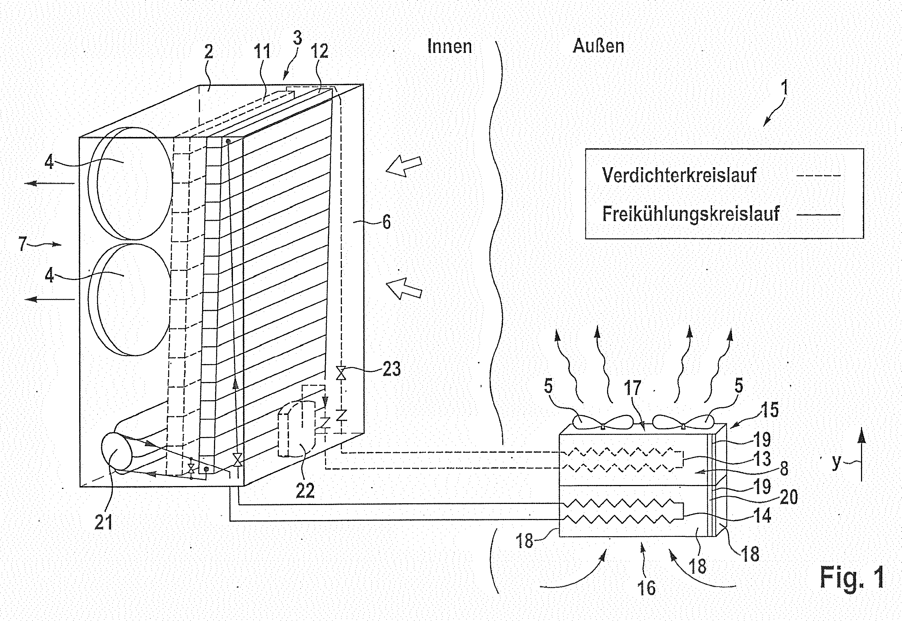

Weitere Einzelheiten der Erfindung werden anhand der nachstehenden Figur 1 veranschaulicht. Diese zeigt in schematischer Darstellung eine beispielhafte Ausführungsform einer erfindungsgemäßen Kühlanordnung.

Die Kühlanordnung 1 weist ein in einer IT-Umgebung, beispielsweise in einem Rechenzentrum, angeordnetes Kühlgerätgehäuse 2 auf, das beispielsweise als ein Inline-Gerät in eine Schaltschrankreihe in einer Kaltgang-Warmgang-Anordnung eingereiht sein kann.

Dementsprechend ist das Kühlgerätgehäuse 2 darauf ausgerichtet, über eine erste von zwei gegenüber liegenden Seiten 6, 7 beispielsweise erwärmte Luft aus einem Warmgang anzusaugen und über eine der ersten Seite gegenüber liegende zweite Seite 7 als gekühlte Luft in einen Kaltgang auszublasen.

Dazu ist in dem Kühlgerätgehäuse 2 ein erstes Wärmetauscherpaket 3 aufgenommen. Zur Erzeugung der beschriebenen Luftströmung weist das Kühlgerätegehäuse 2 mindestens einen ersten Lüfter 4 auf. Im Außenbereich ist ein fluidisch mit dem Kühlgerätegehäuse 2 verbundenes Rückkühlgehäuse 15 angeordnet, das ein darin aufgenommenes zweites Wärmetauscherpaket 8 aufweist. Das Rückkühlgehäuse 15 weist zweite Lüfter 5, die eine definierte Luftströmung in y-Richtung durch das zweite Wärmetauscherpaket 8 hindurch erzeugen.

Das erste und das zweite Wärmetauscherpaket 3, 8 weisen jeweils zwei Luft-Kältemittel-Wärmetauscher 11,12;13,14 auf. Das erste Wärmetauscherpaket 3 weist einen ersten Luft-Kältemittel-Wärmetauscher 11 und einen zweiten Luft-Kältemittel-Wärmetauscher 12 auf. Das zweite Wärmetauscherpaket 8 weist einen dritten Luft-Kältemittel-Wärmetauscher 13 und einen vierten Luft-Kältemittel-Wärmetauscher 14 auf. Der erste Luft-Kältemittel-Wärmetauscher 11 bildet einen Verdampfer eines Verdichterkreislaufes 10, über den der ersten Luft-Kältemittel-Wärmetauscher 11 mit dem dritten Luft-Kältemittel-Wärmetauscher 13 fluidisch verbunden ist, wobei letzterer dementsprechend einen Verflüssiger des Verdichterkreislaufes 10 bildet. Der zweite Luft-Kältemittel-Wärmetauscher 12 ist über einen Freikühlungskreislauf 9 mit dem vierten Luft-Kältemittel-Wärmetauscher 14 fluidisch verbunden. Der Verdichterkreislauf 10 weist neben dem Verdampfer 11 und dem Verflüssiger 13 einen Verdichter 22 und ein Expansionsventil 23 auf. Im Übrigen kann der Verdichterkreislauf nach Art eines üblichen Verdichterkreislaufes ausgebildet sein, wie er für IT-Kühlungsanwendungen aus dem Stand der Technik bekannt ist. Der Verdichterkeislauf 10 und der Freikühlungskreislauf 9 sind fluidisch voneinander getrennt. Der Freikühlungskreislauf 9 weist neben den beiden Luft-Kältemittel-Wärmetauschern 12, 14 eine Pumpe 21 auf, über welche ein Kältemittel zwischen den beiden Luft-Kältemittel-Wärmetauschern 12, 14 zirkuliert ist.

Der dritte und der vierte Luft-Kältemittel-Wärmetauscher 13, 14 sind in dem Rückkühlgehäuse 15 in Vertikalrichtung übereinander angeordnet, wobei die beiden Wärmetauscher 13, 14 gerade in der Vertikalrichtung luftdurchlässig sind, so dass über die zweiten Lüfter 5 eine Luftströmungsrichtung y erzeugt ist, welche gerade in Vertikalrichtung ausgerichtet ist. Die zweiten Lüfter 5 sind gerade darauf ausgerichtet, den Luftstrom in Vertikalrichtung von unten nach oben zu erzeugen. Dadurch durchströmt die Umgebungsluft den vierten Luft-Kältemittel-Wärmetauscher 14 des Freikühlungskreislaufes vor dem dritten Luft-Kältemittel-Wärmetauscher 13 des Verdichterkreislaufs 10, so dass zumindest ein Großteil der erforderlichen Rückkühlleistung von dem vierten Luft-Kältemittel-Wärmetauscher des Freikühlungskreislaufes und damit ein Großteil der erforderlichen Kühlleistung des ersten Wärmetauscherpakets 3 aufgebracht werden kann und der Verdichterkreislauf 10 folglich nur noch einen eventuell fehlenden Kühlleistungsanteil aufbringen muss. Der Verdichterkreislauf 10 kann dazu beispielsweise getaktet mit entsprechend verlängerter Taktperiode betrieben werden. Der Verdichterkreislauf 10 kann jedoch auch einen drehzahlgeregelten Verdichter 22 aufweisen, wobei es die erfindungsgemäße Kühlanordnung erlaubt, dass der Verdichter 22 in einem energieoptimierten, niedrigen Drehzahlbereich betrieben werden kann, um die eventuell noch erforderliche zusätzliche Kühlleistung, die von dem Freikühlungskreislauf 9 nicht aufgebracht werden kann, bereit zu stellen.

Der dritte und der vierte Wärmetauscher 13, 14 sind in dem Kühlgerätegehäuse 15 gestapelt übereinander angeordnet, so dass sie eine kompakte Einheit bilden. Insbesondere kann vorgesehen sein, dass das Rückkühlgehäuse 15 eine Seitenwandeinfassung 18 aufweist, die gerade eine Einfassung des zweiten Wärmetauscherpakets 8 ist und die eine Luftströmungsrichtung durch das zweite Wärmetauscherpaket 8 parallel zu der Seitenwandeinfassung 18 und damit in Vertikalrichtung y definiert. Das zweite Wärmetauscherpaket 8 weist parallele Wärmetauscherlamellen 19 auf, die in y-Richtung durchlässige Luftleitkanäle 20 durch die beiden Wärmetauscher 13, 14 hindurch bilden. Der dritte und der vierte Wärmetauscher 13, 14 können insbesondere derart zueinander ausgerichtet sein, dass die Luftleitkanäle 20 der beiden Wärmetauscher 13, 14 paarweise fluchten, wobei die fluchtenden Luftleitkanäle 20 jeweils zwischen der Lufteinlassseite 16 des vierten Luft-Kältemittel-Wärmetauschers 14 des Freikühlungskreislauf und der Luftauslassseite 17 des Verflüssigers geführt sind. Außer dem zweiten Wärmetauscherpaket 8 muss das Rückkühlgehäuse 15 somit lediglich noch mindestens einen zweiten Lüfter 5 zur Erzeugung der Luftströmung in y-Richtung aufweisen. Es sind keine weiteren aktiven Komponenten wie Verdichter, Expansionsventile oder dergleichen erforderlich, so dass das Rückkühlgehäuse 15 zumindest im Vergleich zu Chillem und anderen aktiven Rückkühlkomponenten konstruktiv einfach gehalten werden kann und einen niedrigen Energieverbrauch aufweist.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Kühlanordnung
- 2: Kühlgerätgehäuse
- 3: erstes Wärmetauscherpaket
- 4: erster Lüfter
- 5: zweiter Lüfter
- 6: Lufteinlassseite
- 7: Luftauslassseite
- 8: zweites Wärmetauscherpaket
- 9: Freikühlungskreislauf
- 10: Verdichterkreislauf
- 11: erster Luft-Kältemittel-Wärmetauscher
- 12: zweiter Luft-Kältemittel-Wärmetauscher
- 13: dritter Luft-Kältemittel-Wärmetauscher
- 14: vierter Luft-Kältemittel-Wärmetauscher
- 15: Rückkühlgehäuse
- 16: Lufteinlassseite des vierten Luft-Kältemittel-Wärmetauschers
- 17: Luftauslassseite des Verflüssigers
- 18: Seitenwandeinfassung
- 19: Wärmetauscherlamelle
- 20: Luftleitkanal
- 21: Pumpe
- 22: Verdichter
- 23: Expansionsventil
- y: Luftströmungsrichtung durch zweites Wärmetauscherpaket

## Patentansprüche

1. Kühlanordnung (1) für die Klimatisierung einer IT-Umgebung und insbesondere für die Rechenzentrumsklimatisierung, mit einem Kühlgerätgehäuse (2), das in einer IT-Umgebung und insbesondere in einem Rechenzentrum aufgestellt ist, und in dem ein erstes Wärmetauscherpaket (3) sowie mindestens ein erster Lüfter (4) aufgenommen sind, wobei der erste Lüfter (4) dazu eingerichtet ist, Luft aus dem Gebäude oder dem Rechenzentrum über eine erste von zwei gegenüber liegenden Gehäuseseiten (6, 7) anzusaugen, durch das Gehäuse (2) und das erste Wärmetauscherpaket (3) hindurch zu befördern und über eine der ersten Gehäuseseite (6) gegenüber liegende zweite Gehäuseseite (7) aus dem Gehäuse (2) auszublasen, und wobei außerhalb des Gebäudes oder Rechenzentrums ein zweites Wärmetauscherpaket (8) angeordnet und von mindestens einem zweiten Lüfter (5) mit Luft durchströmt ist, wobei ein erster und ein zweiter Kältemittelkreislauf (9, 10) fluidisch voneinander getrennt zwischen dem ersten Wärmetauscherpaket (3) und dem zweiten Wärmetauscherpaket (8) geführt sind, wobei der erste Kältemittelkreislauf (9) ein Freikühlungskreislauf und der zweite Kältemittelkreislauf (10) ein Verdichterkreislauf ist, wobei das zweite Wärmetauscherpaket (8) einen dritten Luft-Kältemittel-Wärmetauscher (13), der ein Verflüssiger des Verdichterkreislaufs ist, und einen vierten Luft-Kältemittel-Wärmetauscher (14) aufweist, durch den das flüssige Kältemittel des Freikühlungskreislaufs durchgeleitet ist, **dadurch gekennzeichnet, dass** der dritte und der vierte Wärmetauscher (13, 14) des zweiten Wärmetauscherpakets (8) vertikal übereinander gestapelt in einem Rückkühlgehäuse (15) aufgenommen sind, wobei der Verflüssiger des Verdichterkreislaufs oberhalb des vierten Luft-Kältemittel-Wärmetauscher (14) des Freikühlungskreislaufs angeordnet ist und der Verflüssiger und der vierte Luft-Kältemittel-Wärmetauscher (14) des Freikühlungskreislaufs in Vertikalrichtung nacheinander von der Luft durchströmt sind.

2. Kühlanordnung (1) nach Anspruch 1, bei dem das erste Wärmetauscherpaket (3) einen ersten Luft-Kältemittel-Wärmetauscher (11), der ein Verdampfer des Verdichterkreislaufs ist, und einen zweiten Luft-Kältemittel-Wärmetauscher (12) aufweist, durch den das flüssige Kältemittel des Freikühlungskreislaufs durchgeleitet ist.

3. Kühlanordnung (1) nach einem der vorhergehenden Ansprüche, bei dem die das zweite Wärmetauscherpaket (8) durchströmende Luft in Luftströmungsrichtung (y) durch das das zweite Wärmetauscherpaket (8) den vierten Luft-Kältemittel-Wärmetauscher (14) des Freikühlungskreislaufs vor dem Verflüssiger des Verdichterkreislaufs durchströmt.

4. Kühlanordnung (1) nach einem der vorhergehenden Ansprüche, bei dem eine Lufteinlassseite (16) des vierten Luft-Kältemittel-Wärmetauschers (14) des Freikühlungskreislaufs einen Lufteinlass des zweiten Wärmetauscherpakets (8) und eine Luftauslassseite (17) des Verflüssigers einen Luftauslass des zweiten Wärmetauscherpakets (8) bildet.

5. Kühlanordnung (1) nach einem der vorhergehenden Ansprüche, bei dem Seitenwände des Rückkühlgehäuses (15) von einer umlaufend geschlossenen vertikalen Seitenwandeinfassung (18) des zweiten Wärmetauscherpakets (8) gebildet sind, die den dritten und den vierten Wärmetauscher (13, 14) zueinander ausrichten und seitlich einfassen, so dass eine Luftströmungsrichtung durch das zweite Wärmetauscherpaket (8) parallel zu der Seitenwandeinfassung (18) und damit in Vertikalrichtung gebildet ist.

6. Kühlanordnung (1) nach Anspruch 5, bei dem die Wärmetauscher (13, 14) des zweiten Wärmetauscherpakets (8) parallele Wärmetauscherlamellen (19) aufweisen, von denen benachbarte Wärmetauscherlamellen (19) jeweils einen in Vertikalrichtung durchlässigen Luftleitkanal (20) durch die Wärmetauscher (13, 14) hindurch bilden.

7. Kühlanordnung (1) nach Anspruch 6, bei dem die Luftleitkanäle (20) von dem dritten und dem vierten Wärmetauscher (13, 14) des zweiten Wärmetaucherpakets (8) paarweise fluchtend zueinander ausgerichtet sind, wobei die fluchtenden Luftleitkanäle (20) jeweils zwischen der Lufteinlassseite (16) des vierten Luft-Kältemittel-Wärmetauschers (14) des Freikühlungskreislaufs und der Luftauslassseite (17) des Verflüssigers geführt sind.

## Claims

1. A cooling arrangement (1) for air conditioning an IT environment and in particular for data center air conditioning, with a cooling device housing (2), which is set up in an IT environment and in particular in a data center, and in which a first heat exchanger package (3) and at least one first fan (4) are accommodated, wherein the first fan (4) is set up to suck air from the building or the data center via a first of two opposite housing sides (6, 7), through the housing (2) and the first heat exchanger package (3) and out of the housing (2) via a second housing side (7) opposite the first housing side (6), and wherein a second heat exchanger package (8) is arranged outside the building or data center and has air flowing through it from at least one second fan (5), wherein a first and a second refrigerant circuit (9, 10) are fluidically separated from one another and guided between the first heat exchanger package (3) and the second heat exchanger package (8), the first refrigerant circuit (9) being a free-cooling circuit and the second refrigerant circuit (10) being a compressor circuit, wherein the second heat exchanger package (8) comprises a third air-refrigerant heat exchanger (13), which is a condenser of the compressor circuit, and a fourth air-refrigerant heat exchanger (14), through which the liquid refrigerant of the free cooling circuit is passed, **characterized in that** the third and the fourth heat exchanger (13, 14) of the second heat exchanger package (8) are accommodated vertically stacked one above the other in a recooling housing (15), the condenser of the compressor circuit being arranged above the fourth air-refrigerant heat exchanger (14) of the free-cooling circuit, and the condenser and the fourth air-refrigerant heat exchanger (14) of the free-cooling circuit having the air flowing through them successively in the vertical direction.

2. The cooling arrangement (1) according to claim 1, wherein the first heat exchanger package (3) comprises a first air-refrigerant heat exchanger (11) which is an evaporator of the compressor circuit and a second air-refrigerant heat exchanger (12) through which the liquid refrigerant of the free cooling circuit is passed.

3. The cooling arrangement (1) according to any one of the preceding claims, wherein the air flowing through the second heat exchanger package (8) flows through the fourth air-refrigerant heat exchanger (14) of the free-cooling circuit upstream of the condenser of the compressor circuit in the air flow direction (y) through the second heat exchanger package (8).

4. The cooling arrangement (1) according to any one of the preceding claims, wherein an air inlet side (16) of the fourth air-refrigerant heat exchanger (14) of the free-cooling circuit forms an air inlet of the second heat exchanger package (8) and an air outlet side (17) of the condenser forms an air outlet of the second heat exchanger package (8).

5. The cooling arrangement (1) according to one of the preceding claims, wherein side walls of the recooling housing (15) are formed by a circumferentially closed vertical side wall enclosure (18) of the second heat exchanger package (8), which align and laterally enclose the third and the fourth heat exchanger (13, 14) with respect to each other, so that an air flow direction through the second heat exchanger package (8) is formed parallel to the side wall enclosure (18) and thus in vertical direction.

6. The cooling arrangement (1) according to claim 5, wherein the heat exchangers (13, 14) of the second heat exchanger package (8) comprise parallel heat exchanger fins (19), of which adjacent heat exchanger fins (19) each form an air guide channel (20) through the heat exchangers (13, 14) that is permeable in the vertical direction.

7. The cooling arrangement (1) according to claim 6, wherein the air guide channels (20) of the third and the fourth heat exchanger (13, 14) of the second heat exchanger package (8) are aligned in pairs, wherein the aligned air guide channels (20) are each guided between the air inlet side (16) of the fourth air-refrigerant heat exchanger (14) of the free-cooling circuit and the air outlet side (17) of the condenser.

## Revendications

1. Dispositif de refroidissement (1) pour la climatisation d'un environnement informatique et en particulier pour la climatisation de centres de calcul, avec un carter (2) d'appareil de refroidissement qui est installé dans un environnement informatique et en particulier dans un centre de calcul, et dans lequel sont logés un premier paquet d'échangeur de chaleur (3) ainsi qu'au moins un premier ventilateur (4), le premier ventilateur (4) étant agencé pour aspirer de l'air à partir du bâtiment ou du centre de calcul par le biais d'un premier de deux côtés de carter (6, 7) situés l'un en face de l'autre, pour le transporter à travers le carter (2) et le premier paquet d'échangeur de chaleur (3), et pour l'expulser du carter (2) par le biais d'un deuxième côté de carter (7) situé en face du premier côté de carter (6), et un deuxième paquet d'échangeur de chaleur (8) étant disposé à l'extérieur du bâtiment ou du centre de calcul et étant balayé par de l'air d'au moins un deuxième ventilateur (5), un premier et un deuxième circuit de réfrigérant (9, 10) étant, de façon fluidiquement séparé l'un de l'autre, conduits entre le premier paquet d'échangeur de chaleur (3) et le deuxième paquet d'échangeur de chaleur (8), le premier circuit de réfrigérant (9) étant un circuit de refroidissement naturel, et le deuxième circuit de réfrigérant (10) étant un circuit de compresseur, le deuxième paquet d'échangeur de chaleur (8) comportant un troisième échangeur de chaleur air-réfrigérant (13), qui est un condenseur du circuit de compresseur, et un quatrième échangeur de chaleur air-réfrigérant (14) à travers lequel le réfrigérant liquide du circuit de refroidissement naturel est conduit, **caractérisé en ce que** le troisième et le quatrième échangeur de chaleur (13, 14) du deuxième paquet d'échangeur de chaleur (8) sont logés de façon empilée verticalement l'un au-dessus de l'autre dans un carter de refroidissement de retour (15), le condenseur du circuit de compresseur étant disposé au-dessus du quatrième échangeur de chaleur air-réfrigérant (14) du circuit de refroidissement naturel, et le condenseur et le quatrième échangeur de chaleur air-réfrigérant (14) du circuit de refroidissement naturel étant balayés par l'air l'un après l'autre dans la direction verticale.

2. Dispositif de refroidissement (1) selon la revendication 1, dans lequel le premier paquet d'échangeur de chaleur (3) comporte un premier échangeur de chaleur air-réfrigérant (11), qui est un évaporateur du circuit de compresseur, et un deuxième échangeur de chaleur air-réfrigérant (12) à travers lequel est conduit le réfrigérant liquide du circuit de refroidissement naturel.

3. Dispositif de refroidissement (1) selon l'une des revendications précédentes, dans lequel l'air balayant le deuxième paquet d'échangeur de chaleur (8) balaye dans la direction d'écoulement d'air (y), à travers le deuxième paquet d'échangeur de chaleur (8), le quatrième échangeur de chaleur air-réfrigérant (14) du circuit de refroidissement naturel en amont du condenseur du circuit de compresseur.

4. Dispositif de refroidissement (1) selon l'une des revendications précédentes, dans lequel un côté d'entrée d'air (16) du quatrième échangeur de chaleur air-réfrigérant (14) du circuit de refroidissement naturel forme une entrée d'air du deuxième paquet d'échangeur de chaleur (8), et un côté de sortie d'air (17) du condenseur forme une sortie d'air du deuxième paquet d'échangeur de chaleur (8).

5. Dispositif de refroidissement (1) selon l'une des revendications précédentes, dans lequel des parois latérales du carter de refroidissement de retour (15) sont formées par une bordure de parois latérales (18) verticale du deuxième paquet d'échangeur de chaleur (8) fermée périphériquement, qui alignent l'un par rapport à l'autre le troisième et le quatrième échangeur de chaleur (13, 14) et les bordent latéralement de telle sorte qu'une direction d'écoulement d'air à travers le deuxième paquet d'échangeur de chaleur (8) est formée parallèlement à la bordure de parois latérales (18) et ainsi dans la direction verticale.

6. Dispositif de refroidissement (1) selon la revendication 5, dans lequel les échangeurs de chaleur (13, 14) du deuxième paquet d'échangeur de chaleur (8) comportent des lamelles d'échangeur de chaleur (19) parallèles dont des lamelles d'échangeur de chaleur (19) voisines forment à travers les échangeurs de chaleur (13, 14) respectivement un canal de guidage d'air (20) perméable dans la direction verticale.

7. Dispositif de refroidissement (1) selon la revendication 6, dans lequel les canaux de guidage d'air (20) du troisième et du quatrième échangeur de chaleur (13, 14) du deuxième paquet d'échangeur de chaleur (8) sont alignés l'un par rapport à l'autre par paires, les canaux de guidage d'air (20) alignés étant guidés respectivement entre le côté d'entrée d'air (16) du quatrième échangeur de chaleur air-réfrigérant (14) du circuit de refroidissement naturel et le côté de sortie d'air (17) du condenseur.
